# EUROPÄISCHE PATENTSCHRIFT

(11) **EP 2 573 940 B1**
(45) Veröffentlichungstag und Bekanntmachung des Hinweises auf die Patenterteilung: **28.10.2015**
(21) Anmeldenummer: 12171587.4
(22) Anmeldetag: 12.06.2012
(51) Int. Cl.: H03K 17/94

(54) **Kartenschalter**
Card circuit
Sélecteur à carte

(30) Priorität: 23.09.2011 DE 102011053879
(43) Veröffentlichungstag der Anmeldung: 27.03.2013
(73) Patentinhaber: Albrecht Jung GmbH & Co. KG, 58579 Schalksmühle (DE)
(72) Erfinder: Hartmann, Torsten, 58509 Lüdenscheid (DE); Kohlhaas, Johannes, 58579 Schalksmühle (DE)

(56) Entgegenhaltungen:
- EP-A2- 0 152 678
- WO-A1-00/77330
- DE-B3-102008 017 463
- US-A- 5 594 233

## Beschreibung

Die vorliegende Erfindung geht von einem gemäß Oberbegriff des Hauptanspruches konzipierten Kartenschalter aus.

Derartige Kartenschalter sind oftmals auf Basis herkömmlicher Taster der Gebäudesystemtechnik aufgebaut. Die Betätigung des zugehörigen Tasters wird bei solchen Kartenschaltern durch das Einführen der Karte in den Führungsschlitz bzw. das Herausziehen der Karte aus dem Führungsschlitz bewirkt. Beim Einführen der Karte kommt diese zunächst mit der unteren Hauptfläche an dem Betätigungsglied und mit der oberen Hauptfläche an der Innenseite des Gehäuseoberteils zur Anlage und schaltet dann beim weiteren Einführen z. B. den zugehörigen Taster ein. Mit dem Herausziehen der Karte aus dem Führungsschlitz wird der zugehörige Taster zum Beispiel automatisch wieder ausgeschaltet bzw. zurückgesetzt. Oftmals finden solche Kartenschalter als Schlüsselkartenschalter in Hotels Anwendung, wobei mit der Schlüsselkarte oftmals auch gleichzeitig das Schloss der Zimmertür betätigt werden kann. Nach dem Betreten des Zimmers wird die Schlüsselkarte in den Schlüsselkartenschalter eingesteckt, wodurch alle angeschlossenen elektrischen Verbraucher eingeschaltet werden. Die Schlüsselkarte verbleibt normalerweise im Kartenschalter bis das Zimmer wieder verlassen wird. Durch das Herausnehmen der Schlüsselkarte werden dann alle angeschlossenen elektrischen Verbraucher wieder ausgeschaltet. Oftmals sind solche Karten bzw. Schlüsselkarten mit empfindlichen Oberflächen, wie z. B. Aufdrucken und/oder empfindlichen Funktionselementen, wie z. B. Magnetstreifen versehen.

Durch die WO 00/77330 A1 ist ein dem Oberbegriff des Hauptanspruches entsprechender Kartenschalter bekannt geworden. Bei einem solchen Kartenschalter ist ein mit einem Führungsschlitz für die Karte vorgesehenes Gehäuseoberteil vorhanden. Außerdem weist das Gehäusesockelteil zumindest ein Funktionselement auf, wobei das Gehäuseoberteil und das Gehäusesockelteil ein mit einem

Einsatzgerät koppelbaren Funktionsaufsatz bilden, und wobei im Einsatzgerät und/oder im Funktionsaufsatz zumindest ein Teil einer Anordnung untergebracht ist, welche das Vorhandensein der Karte berührungslos erfasst. Ein dermaßen ausgebildeter Kartenschalter weist jedoch einen vergleichsweise aufwendigen und stark auf die Wand aufbauenden Aufbau auf. Außerdem stellt dieser Kartenschalter ein Einzelgerät dar, welches hinsichtlich seines Designs nicht modulartig in verschiedene Programmlinien (übliche Abdeckprogramme) zu integrieren ist.

Des Weiteren ist durch die DE 10 2008 017 463 B3 ein Kartenschalter bekannt geworden. Bei einem solchen Kartenschalter ist ein mit einem Führungsschlitz für die Karte vorgesehenes Gehäuseoberteil vorhanden. Außerdem ist ein solcher Kartenschalter mit einem die Schaltmechanik eines zugeordneten Tasters aufweisenden Gehäusesockelteil versehen, wobei die Schaltmechanik mit einem, mit der unteren Hauptfläche der Karte zusammen wirkenden Betätigungsglied versehen ist. Das Gehäuseoberteil weist an seiner dem Betätigungsglied zugeordneten Innenfläche des Gehäuseoberteils ein mit der oberen Hauptfläche der Karte zusammenwirkendes Führungsstück auf. Dabei ist davon auszugehen, dass gute Gleiteigenschaften aufweisende Materialen zur Anwendung kommen. Der Aufbau eines solchen Kartenschalters ist jedoch vergleichsweise komplex, und die zur Betätigung notwendigen Schaltkräfte sind vergleichsweise hoch, womit ein erhöhter Kartenverschleiß einhergeht, wenn nicht besondere Gegenmaßnahmen getroffen sind.

Der vorliegenden Erfindung liegt die Aufgabe zugrunde, einen besonders kompakt bauenden und einfach aufgebauten Kartenschalter zu schaffen, dessen zur Betätigung notwendigen Kräfte besonders gering ausfallen, wodurch der Kartenverschleiß minimiert ist, ohne dass zusätzliche Maßnahmen getroffen werden müssen.

Diese Aufgabe wird durch die im Hauptanspruch angegebenen Merkmale gelöst.

Bei einem solchermaßen ausgebildeten Kartenschalter ist besonders vorteilhaft, dass auf die Karte keinerlei Betätigungskräfte einwirken, um die Schaltfunktionen auszulösen, weil die Auslösung der Schaltfunktionen berührungslos erfolgt. Somit ist für eine besonders schonende Handhabung der Karte Sorge getragen.

Weiterhin ist die kompakte Modulbauweise des Kartenschalters besonders vorteilhaft, weil dadurch die Möglichkeit besteht, im Einsatzgerät auf einfache Art und Weise Zusatzfunktionen, wie z. B. die Einstellmöglichkeit einer gewünschten Nachlaufzeit, zu realisieren.

Zudem ist besonders vorteilhaft, eine Beleuchtung des Führungsschlitzes für die Karte vorzusehen, damit der Kartenschalter im Dunkeln für den Benutzer besser aufzufinden ist.

Weitere vorteilhafte Ausgestaltungen sind in den Unteransprüchen angegeben. Anhand zweier in den Zeichnungen näher dargestellten Ausführungsbeispiele sei der erfindungsgemäße Gegenstand näher erläutert. Dabei zeigen:
- Fig. 1:: prinziphaft den Grundaufbau eines solchen Kartenschalters gemäß erstem Ausführungsbeispiel, bestehend aus Einsatzgerät, Designrahmen, Gehäusesockelteil, Lichtleiter und Gehäuseoberteil, sowie eine zugeordnete Karte räumlich in Explosionsdarstellung;
- Fig. 2:: prinziphaft einen gemäß Figur 1 ausgeführten Kartenschalter im Vollschnitt mit eingeschobener Karte;
- Fig.3:: prinziphaft den Grundaufbau eines solchen Kartenschalters gemäß zweitem Ausführungsbeispiel, bestehend aus Einsatzgerät, Designrahmen, Gehäusesockelteil und Gehäuseoberteil, sowie eine zugeordnete Karte räumlich in Explosionsdarstellung;
- Fig.4:: prinziphaft einen gemäß Figur 3 ausgeführten Kartenschalter im Vollschnitt mit eingeschobener Karte.

Wie aus den Zeichnungen hervorgeht, besteht ein solcher Kartenschalter im Wesentlichen aus einem mit einem Führungsschlitz 1 für die Karte 2 versehenen Gehäuseoberteil 3 und einem zumindest ein Funktionselement aufweisenden Gehäusesockelteil 4. Das Gehäuseoberteil 3 und das Gehäusesockelteil 4 bilden einen sogenannten Funktionsaufsatz 3, 4. Zur Verbindung mit einem Gebäudenetzwerk ist ein Einsatzgerät 5 vorgesehen, welches als sogenannter Unterputzeinsatz ausgeführt ist. Gegebenenfalls kann das Gebäudenetzwerk als Bussystem ausgeführt sein. Unter Zwischenschaltung eines Designrahmens D, eines üblichen Abdeckprogramms werden Gehäuseoberteil 3 und Gehäusesockelteil 4, welche den Funktionsaufsatz bilden, an das Einsatzgerät 5 angekoppelt.

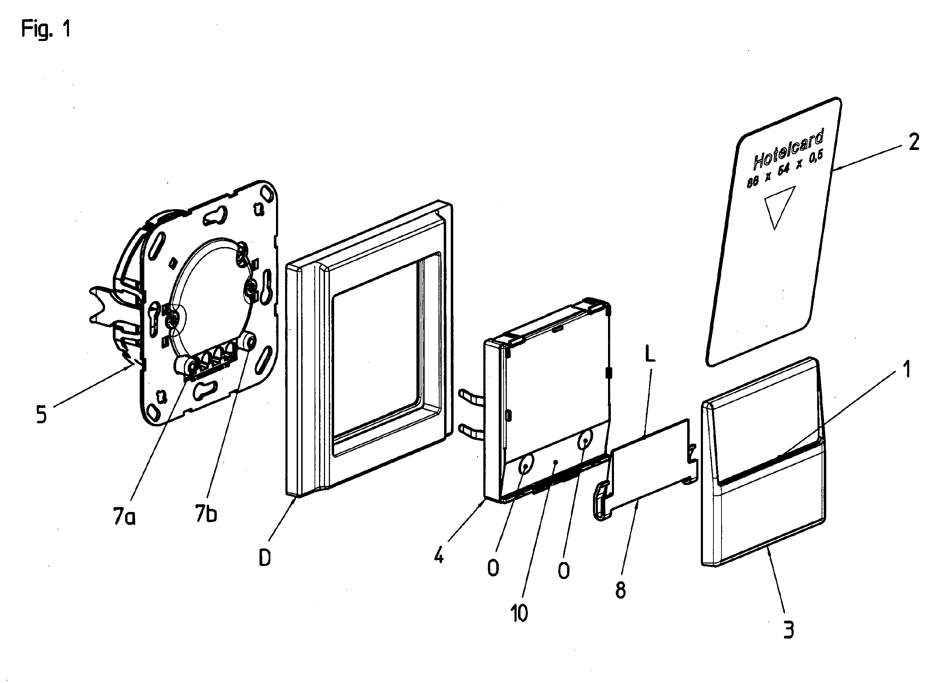

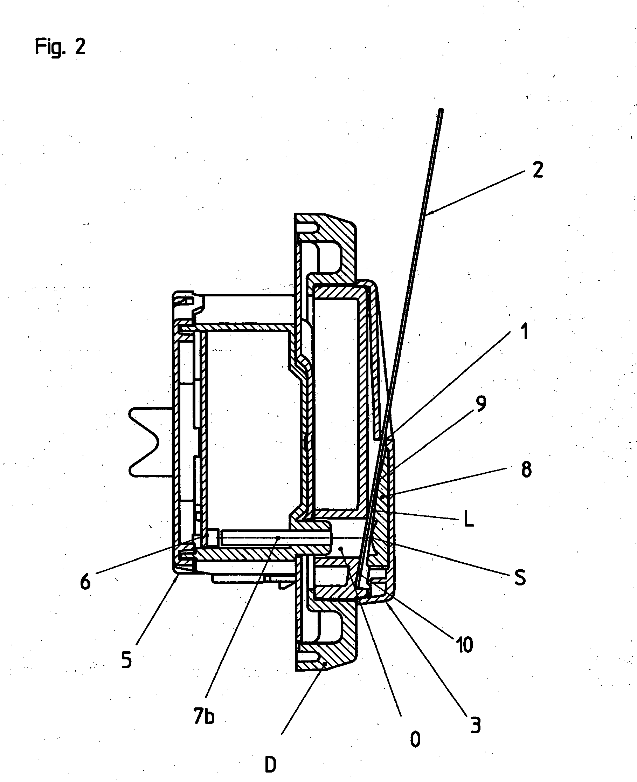

Wie des Weiteren insbesondere aus Figur 1 und Figur 2 hervorgeht, ist die zur berührungslosen Erfassung der Karte 2 vorgesehene Anordnung als Lichtschrankenanordnung ausgeführt. Im vorliegenden Fall besteht die Lichtschrankenanordnung aus einer das Licht aussendenden und wieder empfangenden LED-Sensoreinheit 6, die im Innenraum des Einsatzgerätes 5 untergebracht ist. Zudem gehören ein erster Lichtleiter 7a und ein zweiter Lichtleiter 7b zur Lichtschrankenanordnung, die ebenfalls hauptsächlich im Einsatzgerät 5 angeordnet sind. Die beiden Lichtleiter 7a, 7b ragen mit ihrem Endbereich jeweils in eine entsprechend ausgeführte Öffnung O des Gehäusesockelteils 4 hinein. Außerdem ist ein dritter Lichtleiter 8 zur Lichtschrankenanordnung gehörig, welcher in Zuordnung der beiden Endbereiche der beiden Lichtleiter 7a, 7b an der Innenfläche des Gehäuseoberteils 3 angebracht ist. Um zu erfassen, ob sich die Karte 2 im Kartenschalter befindet, wird von der LED-Sensoreinheit 6 Licht ausgesendet, welches über den Endbereich des ersten Lichtleiters 7a an den dritten Lichtleiter 8 abgegeben wird. Befindet sich keine Karte 2 im Kartenschalter, wird das Licht über entsprechende Lichtleitstrukturen S des dritten Lichtleiters 8 in den Endbereich des zweiten Lichtleiter 7b eingespeist und trifft letztendlich wieder auf die LED-Sensoreinheit 6 zurück. Somit kann eindeutig festgestellt werden, wenn Licht wieder auf die LED-Sensoreinheit 6 zurückfällt, dass keine Karte 2 im Kartenschalter vorhanden ist. Wird der Lichtstrahl jedoch unterbrochen, befindet sich die Karte 2 im Kartenschalter. Das heißt, es kann eindeutig festgestellt werden, wenn kein Licht auf die LED-Sensoreinheit 6 zurück fällt, dass sich die Karte 2 im Kartenschalter befindet. Um das von der LED-Sensoreinheit 6 ausgehende Licht zuverlässig vom ersten Lichtleiter 7a zum zweiten Lichtleiter 7b zu leiten, ist der dritte Lichtleiter 8 mit einer entsprechenden Lichtleitstruktur S versehen. Die Lichtleitstruktur S ist einstückig in den dritten Lichtleiter 8 eingeformt.

Die Hinterleuchtung des Führungsschlitzes 1 wird dadurch realisiert, dass das von der LED-Sensoreinheit 6 ausgehende Licht in den dritten Lichtleiter 8 eingespeist und dann teilweise über dessen Lichtleitstruktur S bzw. dessen Lichtauskoppelfläche L nach außen abgegeben wird. Die Lichtauskoppelfläche L ist dabei dem Führungsschlitz 1 derart zugeordnet, dass auf einfache Art und Weise eine homogene Hinterleuchtung des Führungsschlitzes 1 realisiert ist.

Um den Kartenverschleiß auch hinsichtlich der exakten Führung innerhalb des Kartenschalters besonders gering zu halten, ist das Gehäuseoberteil 3 mit einer mit der Karte 2 zusammenwirkenden ersten Gleitzone 9 versehen und weist das Gehäusesockelteil 4 eine mit der Karte 2 zusammenwirkende zweite Gleitzone 10 auf. Die erste Gleitzone 9 ist an den im Gehäuseoberteil 3 festgelegten dritten Lichtleiter 8 angeformt, wohingegen die zweite Gleitzone 10 an die der Karte 2 zugewandten Oberfläche des Sockelteils 4 angeformt ist.

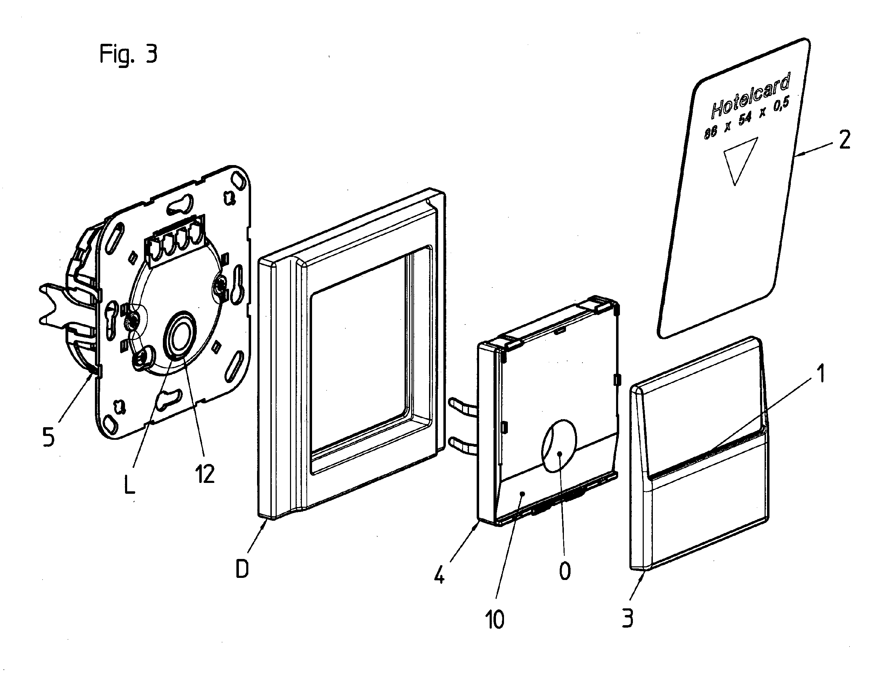

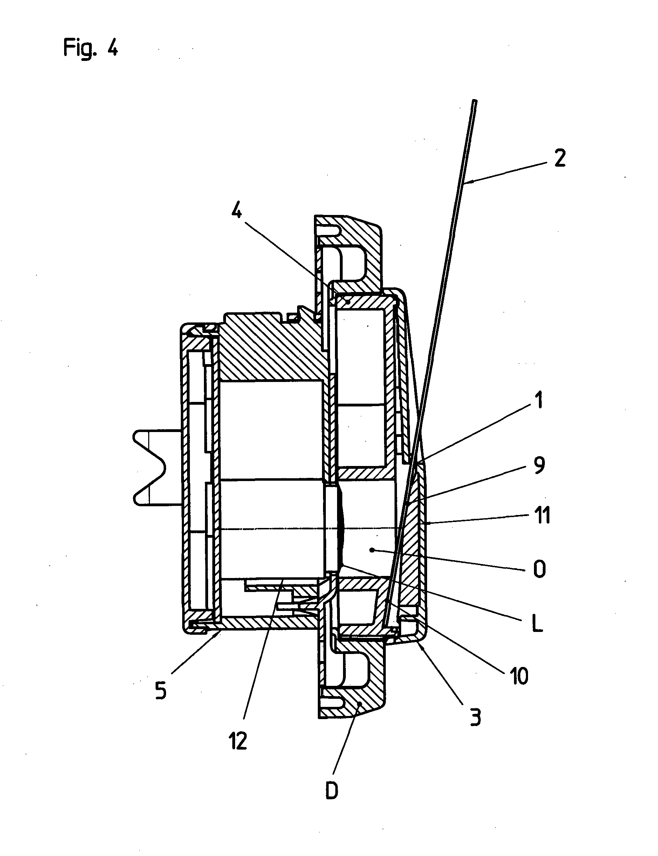

Wie insbesondere aus Figur 3 und Figur 4 hervorgeht, ist die zur berührungslosen Erfassung der Karte 2 vorgesehene Anordnung als Kameraanordnung ausgeführt. Im vorliegenden Fall besteht die Kameraanordnung im Wesentlichen aus einem Kameramodul 12 mit integrierter Beleuchtungseinrichtung. Sowohl das Kameramodul 12 als auch dessen Beleuchtungseinrichtung sind somit im Innenraum des Einsatzgerätes 5 angeordnet. Zur Beobachtung des Führungsschlitzes 1 bzw. der einzuführenden Karte 2 ist im Gehäusesockelteil 4 eine Öffnung O vorhanden. Durch die Öffnung O ist das Kameramodul 12 in der Lage zu beobachten, ob sich eine Karte 2 im Kartenschalter befindet oder ob der Kartenschalter nicht mit einer Karte 2 bestückt ist. Das heißt, über das Kameramodul 12 kann eindeutig festgestellt werden, ob sich eine Karte 2 im Gerät befindet oder nicht. Dazu ist auch die Beleuchtungseinrichtung notwendig, damit zur Beobachtung für das Kameramodul 12 genügend Licht zur Verfügung steht. Die Lichtauskoppelfläche L der Beleuchtungseinrichtung umgibt die Optik des Kameramoduls 12 ringförmig. Wenn eine solche Anordnung ein Kameramodul 12 aufweist, können z. B. als Zusatznutzen verschiedene Funktionsumfänge realisiert werden. Dazu sind auf der Hotelkarte verschiedene Symbole abgebildet, die unterschiedlichen Funktionsumfängen zugeordnet sind. So ist es z. B. möglich, befindet sich ein als Dreieck ausgebildetes Symbol auf der Karte 2, dass für einen ersten Personenkreis als Funktionsumfang nur das Volllicht eingeschaltet wird bzw. eingeschaltet werden kann. Befindet sich zum Beispiel ein als Halbmond ausgebildetes Symbol auf der Karte 2, ist für einen zweiten Personenkreis als Funktionsumfang nicht nur das Einschalten der Beleuchtungseinrichtung inklusive einer Szenensteuerung möglich, sondern es wird diesem zweiten Personenkreis auch der Zugang zum Fernsehprogramm und zum Internet gewährt. Befindet sich z. B. ein als Vollkreis ausgebildetes Symbol auf der Karte 2, ist für einen dritten Personenkreis als Funktionsumfang nicht nur das Einschalten der Beleuchtungseinrichtung inklusive Szenensteuerung möglich, sondern es wird diesem dritten Personenkreis auch der Zugang zum Fernsehprogramm und zum Internet, sowie das Öffnen der Minibar gewährt.

Sollte eine Hinterleuchtung des Führungsschlitzes 1 realisiert werden, so kann dazu das Licht der Beleuchtungseinrichtung des Kameramoduls 12 ausgenutzt werden.

Um den Kartenverschleiß auch hinsichtlich der exakten Führung innerhalb des Kartenschalters besonders gering zu halten, ist das Gehäuseoberteil 3 mit einer mit der Karte 2 zusammenwirkenden ersten Gleitzone 9 versehen und weist das Gehäusesockelteil 4 eine mit der Karte 2 zusammenwirkende zweite Gleitzone 10 auf. Die erste Gleitzone 9 ist an einem im Gehäuseoberteil 3 festgelegten Gleitstück 11 angeformt, wohingegen die zweite Gleitzone 10 an die der Karte 2 zugewandten Oberfläche des Sockelteils 4 angeformt ist.

Wie des Weiteren aus den Figuren 1 bis 4 hervorgeht, ist der Funktionsaufsatz 3, 4 unter Zwischenschaltung eines Designrahmens D modulartig mit dem Einsatzgerät 5 verbunden. Über ein der Einfachheit halber nicht dargestelltes Steckerteil und am Gehäusesockelteil 4 vorhandene Klemmfedern 13 ist dabei auf einfache Art und Weise eine elektrische und mechanische Verbindung des Funktionsaufsatzes 3, 4 mit dem Einsatzgerät 5 ausgeführt.

## Patentansprüche

1. Kartenschalter mit einem den Führungsschlitz (1) für die Karte (2) aufweisenden Gehäuseoberteil (3) und mit einem zumindest ein Funktionselement aufweisenden Gehäusesockelteil (4), wobei das Gehäuseoberteil (3) und das Gehäusesockelteil (4) ein mit einem Unterputzeinsatzgerät (5) gekoppelten Funktionsaufsatz bilden, wobei im Unterputzeinsatzgerät (5) und/oder im Funktionsaufsatz (3, 4) zumindest ein Teil einer Anordnung untergebracht ist, welche das Vorhandensein der Karte (2) berührungslos erfasst, wobei zur Hinterleuchtung des im Gehäuseoberteil (3) vorhandenen Führungsschlitzes (1) im Gehäusesockelteil (4) und/oder im Unterputzeinsatzgerät (5) eine zumindest ein Leuchtmittel aufweisende Beleuchtungseinrichtung vorhanden ist, und das Gehäuseoberteil (3) zumindest eine mit einer ersten Hauptfläche der Karte (2) zusammenwirkende erste Gleitzone (9) **dadurch gekennzeichnet, dass** der Funktionsaufsatz (3, 4) unter Zwischenschaltung eines Designrahmens (D) eines Abdeckprogramms über ein Steckerteil und über am Gehäusesockelteil (4) vorhandene Klemmfedern elektrisch und mechanisch mit dem Unterputzeinsatzgerät (5) verbunden ist, und dass aufweist das Gehäusesockelteil (4) zumindest eine mit einer zweiten Hauptfläche der Karte (2) zusammenwirkende zweite Gleitzone (10) aufweist.

2. Kartenschalter nach Anspruch 1, **dadurch gekennzeichnet, dass** die die Karte (2) berührungslos erfassende Anordnung als Lichtschrankenanordnung ausgeführt ist.

3. Kartenschalter nach Anspruch 1, **dadurch gekennzeichnet, dass** die die Karte (2) berührungslos erfassende Anordnung als Kameramodul (12) ausgeführt ist.

4. Kartenschalter nach einem der Ansprüche 1 bis 3, **dadurch gekennzeichnet, dass** der Funktionsaufsatz (3, 4) und/oder das Unterputzeinsatzgerät (5) mit zumindest einem Lichtleiter (7a, 7b, 8) versehen ist.

5. Kartenschalter nach einem der Ansprüche 1 bis 4, **dadurch gekennzeichnet, dass** dem Führungsschlitz (1) zur Hinterleuchtung zumindest ein Lichtleiter (8) mit seiner Lichtauskoppelfläche (L) zugeordnet ist.

6. Kartenschalter nach einem der Ansprüche 1 bis 5, **dadurch gekennzeichnet, dass** das Gehäuseoberteil (3) mit zumindest einer Licht reflektierenden Reflektionsfläche versehen ist.

7. Kartenschalter nach Anspruch 3, **dadurch gekennzeichnet, dass** dieser mit einer Funktionsumfangserfassungseinrichtung ausgerüstet ist.

## Claims

1. Key card switch with an upper part of the housing (3) providing the guide slot (1) for the card (2) and with a housing base (4) providing at least one functional element, wherein the upper part of the housing (3) and the housing base (4) form a functional top part coupled with a flush-mounted device (5), wherein in the flush-mounted device (5) and/or in the functional top part (3, 4) at least one part of the unit is housed which contactlessly detects the presence of the card (2), wherein for backlighting of the guide slot (1) provided in the upper part of the housing (3) in the housing base (4) and/or in the flush-mounted device (5) a lighting appliance with at least one luminaire is provided, and the upper part of the housing (3) has at least one first glide zone (9) interacting with a first main surface of the card (2), **characterized by** the fact that the functional top part (3, 4) by interconnection of a design frame (D) of a cover programme, is electrically and mechanically connected with the flush-mounted device (5) via a plug and via clamping springs at the housing base (4) and that the housing base (4) has at least one second glide zone (10) interacting with the second main surface of the card (2).

2. Key card switch in accordance with Claim 1, **characterized by** the fact that the unit detecting the card (2) contactlessly is designed as light barrier unit.

3. Key card switch in accordance with Claim 1, **characterized by** the fact that the unit detecting the card (2) contactlessly is designed as camera module (12).

4. Key card switch in accordance with any of Claims 1 to 3, **characterized by** the fact that the functional top part (3, 4) and/or the flush-mounted device (5) is provided with at least one light conductor (7a, 7b, 8).

5. Key card switch in accordance with any of Claims 1 to 4, **characterized by** the fact that for backlighting of the guide slot (1) at least one light conductor (8) with its light extraction surface (L) is assigned to the guide slot (1).

6. Key card switch in accordance with any of Claims 1 to 5, **characterized by** the fact that the upper part of the housing (3) is provided with at least one light reflecting surface.

7. Key card switch in accordance with Claim 3, **characterized by** the fact that it is equipped with a detection unit for the range of functions.

## Revendications

1. Commutateur à commande par carte avec une partie supérieure de boîtier (3) présentant une fente d'introduction (1) de la carte (2), et avec un élément socle de boîtier (4) présentant au moins un élément fonctionnel, la partie supérieure du boîtier (3) et l'élément socle du boîtier (4) formant un élément fonctionnel rapporté couplé à un appareil encastré (5), au moins une partie d'un système détectant sans contact la présence de la carte (2) étant logé dans l'appareil encastré (5) et/ou l'élément fonctionnel (3, 4), étant donné que, pour le rétroéclairage de la fente d'introduction (1) existant dans la partie supérieure du boîtier (3), un dispositif d'éclairage présentant au moins une ampoule est présent dans l'élément socle du boîtier (4) et/ou dans l'appareil encastré (5), et étant donné que la partie supérieure du boîtier (3) présente au moins une première zone de glissement (9) agissant ensemble avec une première surface principale de la carte (2), **caractérisé en ce que** l'élément fonctionnel (3, 4) est relié électriquement et mécaniquement à l'appareil encastré (5) par une prise et par des ressorts de serrage au niveau de l'élément socle du boîtier (4), un cadre design (D) d'un programme de recouvrement étant placé en intermédiaire, et **en ce que** l'élément socle de boîtier (4) présente au moins une seconde zone de glissement (10) agissant ensemble avec une seconde surface principale de la carte (2).

2. Commutateur à commande par carte selon la revendication 1, **caractérisé en ce que** le système détectant sans contact la présence de la carte (2) est un système de barrière photo-électrique.

3. Commutateur à commande par carte selon la revendication 1, **caractérisé en ce que** le système détectant sans contact la présence de la carte (2) est un module de caméra.

4. Commutateur à commande par carte selon l'une des revendications 1 à 3, **caractérisé en ce que** l'élément fonctionnel (3, 4) et/ou l'appareil encastré (5) est/sont muni(s) d'un guidage de la lumière (7a, 7b, 7c).

5. Commutateur à commande par carte selon l'une des revendications 1 à 4, **caractérisé en ce que** au moins un guidage de la lumière (8) et sa surface d'émission de la lumière (L) sont attribués à la fente d'introduction (1) pour le rétroéclairage.

6. Commutateur à commande par carte selon l'une des revendications 1 à 5, **caractérisé en ce que** la partie supérieure du boîtier (3) est munie d'au moins une surface de réflexion de la lumière.

7. Commutateur à commande par carte selon la revendication 3, **caractérisé en ce que** celui-ci est équipé d'un dispositif de saisie des fonctionnalités.
